# EUROPEAN PATENT APPLICATION

(11) **EP 3 493 659 A1**
(43) Date of publication of application: **05.06.2019**
(21) Application number: 17836892.4
(22) Date of filing: 30.07.2017
(51) Int. Cl.: H05K 3/34, B23K 1/00, B23K 3/02, B23K 3/06, B23K 101/42

(54) **SOLDERING DEVICE AND SOLDERING METHOD**

(30) Priority: 30.07.2016 JP 2016150884; 25.04.2017 JP 2017085859
(71) Applicant: Parat Co., Ltd., Osaka-shi, Osaka 542-0063 (JP)
(72) Inventor: NAKA,Shinichiro, Higashiosaka-shi Osaka 578-0924 (JP); NAKA,Iwao, Higashiosaka-shi Osaka 578-0924 (JP)
(74) Representative: Cabinet Plasseraud
(86) International application number: PCT/JP2017/027581
(87) International publication number: WO 2018/025787

(57) **Abstract**

Present invention is provided for preventing defective soldering. Provided is a method of manufacturing a soldered product which includes: a nozzle approaching step where a first conductor and nozzles 24, 124, 224, 324, 524, 624 are made to approach each other or are brought into contact with each other; a solder piece supplying step where supplied solder pieces 2a, 202a are inserted into the nozzles 24, 124, 224, 324, 524, 624; and a melting step where the solder pieces 2a, 202a in the nozzle are melted by heating the solder pieces 2a, 202a in the nozzle by a heater 36, wherein the nozzles 24, 124, 224, 324, 524, 624 include a falling restricting portion which restricts falling of a lower end portion of the solder pieces 2a, 202a before being melted or a portion in a vicinity of the lower end portion from a state where the lower end portion or the portion in the vicinity of the lower end portion is brought into contact with a solder piece supply side surface of the first conductor, and the melting step is configured such that the solder piece is melted at a position where falling of the lower end portion of the solder piece or the portion in the vicinity of the lower end portion is restricted by the falling restricting portion.

## Description

### TECHNICAL FIELD

The present invention relates to, for example, a soldering apparatus, a soldering method, a method of manufacturing a printed circuit board, a method of manufacturing a product, a method of manufacturing a soldered product and a soldered product where a first conductor such as a terminal or a suitable lead terminal which passes through a hole formed in a board and is connected to an electronic part is soldered to a second conductor such as a land of the board or a button battery.

### BACKGROUND ART

Conventionally, there has been proposed a soldering apparatus which mechanically solders an electronic part to a printed circuit board. With respect to the soldering apparatus, there have been proposed various methods such as a flow soldering method where soldering is performed by bringing a printed circuit board into contact with a liquid surface of the solder, a reflow soldering method where soldering is performed by printing creamy solder to a board in conformity with a pattern in advance, and creamy solder is melted by applying heat to the creamy solder.

The applicant of the present invention has developed and proposed a soldering apparatus where soldering is performed such that a cylindrical solder iron is used, a pin of an electronic part which is made to pass through a through hole formed in a printed circuit board is inserted in the solder iron, and solder is melted in the solder iron (see Patent Literature 1).

Then, a temperature of the solder iron, the position of the solder iron, weight of the solder iron and a supply amount of the solder are confirmed at predetermined timing such as a point of time that the apparatus is started or during an operation of the apparatus thus realizing the further enhancement of reliability and certainty of soldering (see Patent Literature 2).

However, on a working site where soldering is performed in a large amount, there has been a case where defective soldering occurs due to irregularities.

### CITATION LIST

### PATENT LITERATURE

Patent Literature 1: JP 2013-120869 A
Patent Literature 2: JP 2015-115427 A

### SUMMARY OF THE INVENTION

### TECHNICAL PROBLEMS

The present invention has been made in view of the above-mentioned drawbacks, and it is an object of the present invention to provide a soldering apparatus, a soldering method, a method of manufacturing a printed circuit board, a method of manufacturing a product, a method of manufacturing a soldered product, and a soldered product which can prevent the occurrence of defective soldering.

### SOLUTION TO PROBLEMS

The present invention provides a soldering apparatus for soldering a terminal and an object to be connected which is electrically connected to the terminal to each other, wherein the soldering apparatus includes: a cylindrical nozzle into which at least a distal end of the terminal is inserted or which at least the distal end approaches; a solder piece supply unit for supplying a solder piece to the inside of the nozzle; a heating unit for melting the solder piece by heating; a relative distance changing unit for changing a relative distance between the terminal and the nozzle in an approaching or moving-away direction; and a contact position restricting unit which brings an end portion of the solder piece on a terminal side before being melted supplied to the inside of the nozzle into contact with the terminal thus restricting the solder piece before being melted to be held in the nozzle by preventing the solder piece from coming into contact with the object to be connected, wherein the contact position restricting unit is formed of an inner wall of the nozzle where a distance between the inner wall of the nozzle and a side surface of the terminal is set shorter than a minimum width of the solder piece before being melted or a guide portion which guides the solder piece before being melted to the contact position in a predetermined posture thus restricting a movable range of the solder piece in a direction perpendicular to a guiding direction.

The present invention also provides a soldering method, a method of manufacturing a printed circuit board, a method of manufacturing a product, a method of manufacturing a soldered product, and a soldered product.

### ADVANTAGEOUS EFFECTS OF INVENTION

According to the present invention, it is possible to provide a soldering apparatus, a soldering method, a method of manufacturing a printed circuit board, a method of manufacturing a product, a method of manufacturing a soldered product, and a soldered product which can prevent defective soldering.

### BRIEF DESCRIPTION OF THE DRAWINGS

Fig. 1 is a right side view of a soldering apparatus.
Fig. 2 is an explanatory view of an external appearance of the soldering apparatus.
Fig. 3 is an enlarged cross-sectional view showing a configuration of a nozzle unit and a heater unit.
Fig. 4 is a block diagram showing a configuration of a drive system and a control system of the soldering apparatus.
Fig. 5 is a view for schematically describing functions of respective parts of the nozzle.
Fig. 6 is a view schematically showing deformation and the manner of operation of a solder piece in the nozzle at the time of soldering.
Fig. 7 is an explanatory view of a nozzle of an embodiment 2.
Fig. 8 is an explanatory view of a nozzle of an embodiment 3.
Fig. 9 is an explanatory view of a nozzle of an embodiment 4.
Fig. 10 is an explanatory view of nozzles of embodiments 5 to 8.
Fig. 11 is an explanatory view of nozzles of embodiments 9 and 10.

### DESCRIPTION OF EMBODIMENTS

Hereinafter, one embodiment of the invention is described with reference to drawings.

### EMBODIMENT 1

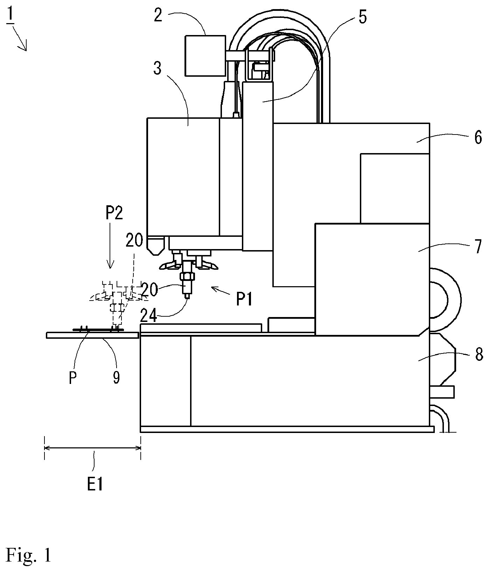

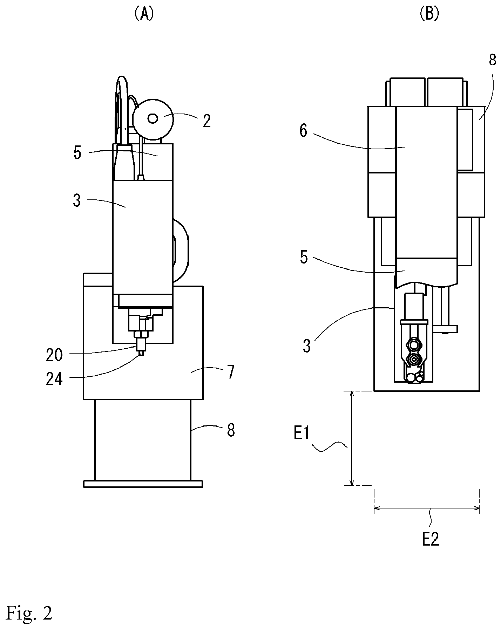

Fig. 1 and Fig. 2 are explanatory views of an external appearance of a soldering apparatus 1, wherein Fig. 1 is a right side view, Fig. 2 (A) is a front view, and Fig. 2 (B) is a plan view of the soldering apparatus 1 with a part of an exterior of a head portion 3 omitted.

As shown in Fig. 1, the soldering apparatus 1 includes: a head portion 3 having a nozzle 24 (solder iron) for applying soldering to a through hole of a printed circuit board P which is an object to be soldered; an air suspension unit 5 which brings the head portion 3 and the nozzle 24 into a floating state; an approaching or moving-away direction moving unit 6 which moves the air suspension unit 5 and the nozzle 24 in a direction approaching or moving away from an object to be soldered (vertical direction in Fig. 1); a conveyance direction moving unit 7 which moves the approaching or moving-away direction moving unit 6 and the nozzle 24 in a conveyance direction along which the printed circuit board P is conveyed (in a depth direction in Fig. 1, a lateral direction in Fig. 2 (A)); and a conveyance width direction moving unit 8 which moves the conveyance direction moving unit 7 and the nozzle 24 in a conveyance width direction of the conveyance direction moving unit 7 (lateral direction in Fig. 1, a longitudinal direction in Fig. 2(A)).

On an upper portion of the air suspension unit 5, a wire solder 2 wound around a reel is disposed. As the wire solder 2, a wire solder having a diameter of φ0.3 to φ2.0 mm can be used, and it is preferable to use a wire solder having a diameter of φ0.6 to φ1.6 mm.

On a lower portion of the head portion 3, a nozzle unit 20 having the nozzle 24 is mounted.

An upper surface of the conveyance width direction moving unit 8 is disposed substantially at the same height as an upper surface of a conveyance path 9 for conveying the printed circuit board P.

A movable range of the head portion 3 is defined by a standby position positioned above the conveyance width direction moving unit 8 (a position P1 shown in Fig. 1) and soldering regions E1, E2 (regions surrounded by E1, E2 in Fig. 2 (B)) where soldering is applied to the printed circuit board P. The head portion 3 is moved by the approaching or moving-away direction moving unit 6 at the standby position and at any positions in the soldering regions.

With such a configuration, in a standby state of the soldering apparatus 1, the nozzle unit 20 stands by at the height and the position of the standby position P1, and in performing a soldering step, soldering is performed within the soldering regions E1, E2 and at the height of the soldering position P2 lower than the standby position P1 (closer to an object to be soldered).

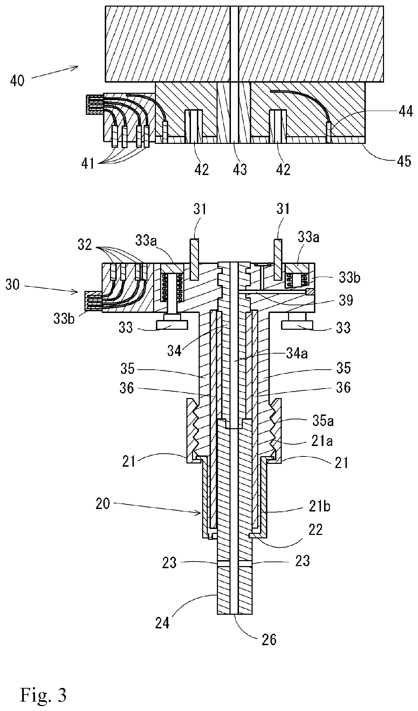

Fig. 3 is an enlarged cross-sectional view showing a configuration of the nozzle unit 20 and a heater unit 30. With respect to the configuration in the vicinity of the nozzle unit 20, there are provided: a heater unit mounting unit 40 on which the heater unit 30 is detachably mounted; the heater unit 30 for heating the wire solder 2 (see Fig. 1); and the nozzle unit 20 having the nozzle 24.

The nozzle unit 20 includes: the nozzle 24 which forms a solder iron; and a nozzle holder 21 (a detachably mounting unit, a nozzle unit fixing unit) for mounting and dismounting the nozzle 24 on and from the heater unit 30.

The nozzle 24 has a circular cylindrical shape, and a circular columnar hole 26 is formed at the center of the nozzle 24. The hole 26 is continuously formed from a distal end side 25a where a terminal T (first conductor) is inserted to a proximal portion side 25b where a solder piece 2a is supplied. The nozzle 24 also has side holes 23 which connect the hole 26 and the outside to each other at a position in the vicinity of a distal end portion where soldering is performed. Due to the formation of the side holes 23, fume generated in the nozzle 24 can be discharged to the outside.

On a proximal portion side (upper side in the drawing) of the nozzle 24, a nozzle holder 21 is disposed. The nozzle holder 21 surrounds an outer periphery of the nozzle 24, and a threaded groove 21a (female threads) for fixing is formed on an inner surface of the nozzle holder 21. The nozzle holder 21 is fixed to the nozzle 24 in a state where the nozzle holder 21 is not rotated relative to the nozzle 24 by a rotation stop portion 22. The threaded groove 21a of the nozzle holder 21 is fixed to a threaded groove 35a (male threads) of the heater unit 30 by threaded engagement. A circular cylindrical space 21b into which a cylindrical heater 36 is inserted is formed between an inner side of the nozzle holder 21 and an outer side of the nozzle 24. The space 21b is formed from a proximal portion of the nozzle 24 to a position slightly on a distal end side of the center.

The heater unit 30 includes: a heater holder 35 where a proximal portion side (an upper side in the drawing) forms a mounting side and a distal end side (a lower portion side in the drawing) is formed into an approximately circular cylindrical shape; the heater 36 (heating unit) having a circular cylindrical shape and disposed inside the heater holder 35; and a solder introducing cylinder 34 having a circular cylindrical shape and disposed inside the heater 36.

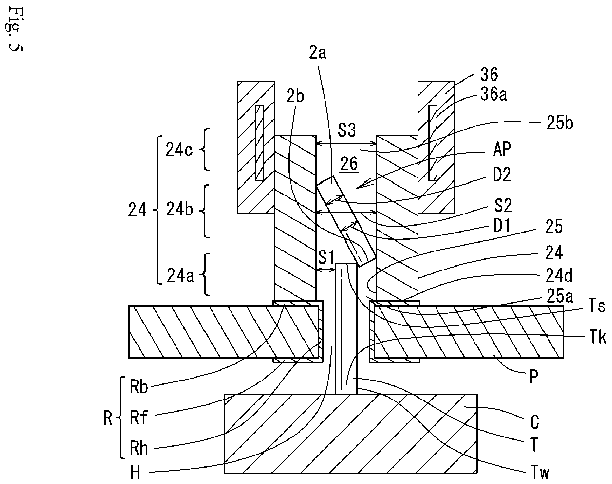

The heater 36 is preferably formed in an axially symmetrical shape. It is more preferable that the heater 36 be formed to heat the nozzle 24 inside the heater 36 approximately uniformly from the periphery of the nozzle 24. In this embodiment, the heater 36 is formed into a circular cylindrical shape. The heater 36 is made of ceramic, and a coil 36a for generating heat (see Fig. 5) is disposed in the heater 36.

The solder introducing cylinder 34 is formed such that a distal end of the solder introducing cylinder 34 is brought into contact with the proximal portion of the nozzle 24 which is inserted into the inside of the heater 36, and a hole 34a formed in the solder introducing cylinder 34 is communicated with the hole 26 formed in the nozzle 24.

With such a configuration, a cut solder piece 2a supplied from above passes through the hole 34a and the hole 26, and is heated and melted by the nozzle 24 heated by the heater 36. In such an operation, the heater 36 functions as a heating unit for heating the solder piece 2a by way of the nozzle 24.

On a proximal portion side (an upper portion side in the drawing) of the heater holder 35, positioning pins 31 which protrude from a connection side surface (an upper surface in the drawing) of the heater holder 35, magnets 33a disposed on the connection side surface, and connectors 32 disposed on the connection side surface are provided.

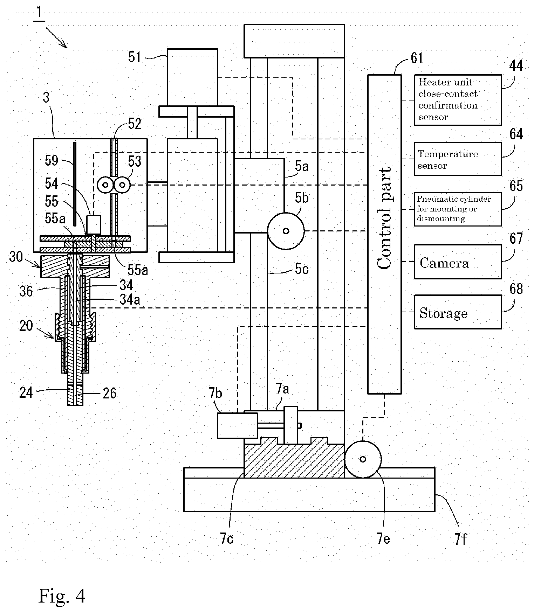

The magnets 33a are fixed to knobs 33 for detachable mounting of the heater unit 30 (a detachably mounting unit, a heater unit fixing unit) respectively, and are biased toward a mounting unit 40 side by springs 33b respectively. Due to attraction of a metal plate 45 of the mounting unit 40 to the magnets 33a by a magnetic force, the heater unit 30 is fixed to the mounting unit 40. On the other hand, in removing the heater unit 30, when the knobs 33 for detachable mounting are pulled in a solder introducing direction (toward a lower side in the drawing) using a pneumatic cylinder 65 for detachable mounting (see Fig. 4), the magnets 33a are moved away from the metal plate 45 so that an attraction force generated by a magnetic force is decreased whereby the heater unit 30 can be removed.

The connectors 32 are connected to connecter pins 41 of the mounting unit 40 respectively thus realizing power supply to the heater 36 and a temperature sensor 64 (see Fig. 4) through a heater power source line and a temperature sensor line.

The positioning pins 31 are inserted into positioning bushings 42 which are formed in a mounting surface side (a lower surface side in the drawing) of the mounting unit 40 respectively thus positioning the relative position between the mounting unit 40 and the heater unit 30. With such a configuration, a solder introducing hole 43 formed in the mounting unit 40 and the hole 34a of the heater unit 30 are communicably connected with each other thus enabling the smooth supply of a cut wire solder 2 (see Fig. 1).

In the mounting unit 40, the solder introducing hole 43 which penetrates the mounting unit 40 in a mounting direction of the heater unit 30 is formed. The metal plate 45 is mounted on a connecting surface side (a lower surface side in the drawing) of the mounting unit 40. On a connecting surface side (the lower surface side in the drawing) of the mounting unit 40, the connecter pins 41 connected to a control part 61 (control unit, see Fig. 4), the positioning bushings 42, and a heater unit close-contact confirmation sensor 44 are disposed.

The heater unit close-contact confirmation sensor 44 is formed of a suitable sensor such as a proximity sensor, and detects whether or not the heater unit 30 is brought into close contact with the mounting unit 40.

Fig. 4 is a block diagram showing a configuration of a drive system and a control system of the soldering apparatus 1. The soldering apparatus 1 includes: a conveyance guide 7f n a Y direction fixed to the conveyance width direction moving unit 8 (see Fig. 1) and extending straightly toward the conveyance path 9 (see Fig. 1); and a conveyance guide 7c which moves along the conveyance guide 7f by a drive mechanism part 7e such as a stepping motor. The drive mechanism part 7e and the conveyance guide 7f are housed in the conveyance width direction moving unit 8 (see Fig. 1). The conveyance guide 7c extends straightly in a conveyance direction (X direction) of the conveyance path 9.

On an upper portion of the conveyance guide 7c in the X direction, a moving body 7a which moves in the X direction along the conveyance guide 7c, and a drive mechanism part 7b formed of a stepping motor or the like for moving the moving body 7a in the X direction along the conveyance guide 7c are disposed. The moving body 7a, the drive mechanism part 7b, and the conveyance guide 7c are housed in the conveyance direction moving unit 7 (see Fig. 1). The moving body 7a, the drive mechanism part 7b, the conveyance guide 7c, the drive mechanism part 7e, and the conveyance guide 7f function as a nozzle position moving unit for moving the nozzle 24 to an arbitrary position where an operation is scheduled to be performed.

The moving body 7a includes a conveyance guide 5c in a Z direction which extends in a direction along which the nozzle 24 approaches or moves away from the through hole. The conveyance guide 5c includes: a head fixing portion 5a which moves in the Z direction; and a drive mechanism part 5b which is formed of a stepping motor or the like. The head fixing portion 5a, the drive mechanism part 5b, and the conveyance guide 5c function as an approaching or moving-away direction moving unit for moving the nozzle 24 in a direction along which the nozzle 24 approaches and moves away from an object to be soldered, and are housed in the approaching or moving-away direction moving unit 6 (see Fig. 1).

By making the conveyance guide 7f in the Y direction, the conveyance guide 7c in the X direction and the drive mechanism parts 7b, 7e having the above-mentioned configuration function as the nozzle position moving unit, the position of the nozzle 24 can be moved to an arbitrary position where soldering is performed. Further, by making the conveyance guide 5c and the drive mechanism part 5b in the Z direction function as the approaching or moving-away direction moving unit, the nozzle 24 is moved in an approaching direction at the moved position, a pin to be soldered is inserted into the hole 26 of the nozzle 24, a distal end of the nozzle 24 is brought into contact with the through hole, and the nozzle 24 can be moved away from an object to be soldered after soldering. Further, due to the conveyance guide 5c and the drive mechanism part 5b in the Z direction, the nozzle 24 is moved in a direction approaching a nozzle unit 20 and a heater unit 30 for replacement at a nozzle station 13, and the nozzle 24 is moved away from the nozzle station 13 after exchanging the nozzle unit 20 or the heater unit 30.

The head fixing portion 5a includes a floating unit 51. The floating unit 51 is disposed in the air suspension unit 5 (see Fig. 1). The floating unit 51 lifts the nozzle unit 20 by air supplied to the floating unit 51 thus reducing a relative weight of the floating unit 51 (including the nozzle 24) to the printed circuit board P. For example, assuming a normal weight of the floating unit 51 as 100, the floating unit 51 can be suitably formed to reduce the weight of the floating unit 51 to 10% of the normal weight.

The head portion 3 includes: a wire solder supply passage 52 which is fixed to the floating unit 51 and allows a wire solder 2 (see Fig. 1) to pass therethrough; and a wire solder feeding mechanism part 53 (solder supply unit) for feeding a wire solder disposed in the wire solder supply passage 52 by sandwiching the wire solder using rollers. The heater unit 30 is disposed on a bottom portion of the head portion 3.

An upper portion of the heater unit 30 includes: a rotary cutter 55 which cuts a wire solder 2 (see Fig. 1) inserted into a hole 55a by rotation; and a rotary mechanism part 54 such as a stepping motor for rotating the rotary cutter 55. The hole 55a having a length equal to a thickness of the disc-like rotary cutter 55 is formed as a hole having a length equal to a length of a required wire solder 2. A length of the hole 55a and a length of a cut solder piece 2a can be set to 1 to 30 mm, and it is preferable to set the lengths to 2 to 15 mm. When the rotary cutter 55 rotates in a state where a required amount of wire solder 2 is inserted into the hole 55a by the wire solder feeding mechanism part 53, the wire solder 2 is cut to an insertion length of the hole 55a and, at the same time, the hole 55a which has been communicated with the wire solder supply passage 52 before cutting of the wire solder 2 moves and is communicated with the hole 34a formed in the solder introducing cylinder 34. In a state where the hole 55a is communicated with the hole 34a, the cut wire solder 2 is forcibly made to fall in the solder introducing cylinder 34 by a pushing rod 59.

Further, to drive the respective constitutional elements, the respective elements are controlled by the control part 61. To the control part 61, the drive mechanism part 5b, the drive mechanism part 7b, the drive mechanism part 7e, the floating unit 51, the wire solder feeding mechanism part 53, the rotary mechanism part 54, the heater unit close-contact confirmation sensor 44, a temperature sensor 64, a detachably mounting pneumatic cylinder 65, a camera 67, and a memory part 68 are connected.

The camera 67 is used at the time of performing positioning of a printed circuit board which is an object to be soldered by confirming positions or the like of through holes and pins formed on the printed circuit board. The camera 67 is also used at the time of performing the detection of defective soldering such as generation of red eyes on a printed circuit board or the like.

The memory part 68 stores data such as data on tools for individual workpieces to be soldered such as printed circuited boards where an image of each workpiece to be soldered and a tool (nozzle 24, nozzle unit 20 or the heater unit 30) used for the workpiece to be soldered are associated with each other, data on a kind of a currently mounting tool, data on the number of times of use and an in-use time of the currently mounting tool.

### <Object to be soldered>

Fig. 5 is an end view schematically showing the nozzle 24 for soldering an electronic part C to the printed circuit board P and an area around the nozzle 24.

A through hole H is formed in the printed circuit board P, and a land R (object to be connected, second conductor) is disposed around the through hole H. The land R is formed of an integral conductive thin film formed of: a ring-shaped land surface portion Rf on a surface side (a lower surface side in Fig. 5) of the printed circuit board P; a ring-shaped land back surface portion Rb on a back surface side (an upper surface side in Fig. 5); and a circular cylindrical land inner peripheral portion Rh on an inner peripheral surface of the through hole H.

Into the through hole H of the printed circuit board P, a terminal T of the electronic part C is inserted in a direction from a surface side to a back surface side (in a direction from a lower surface side to an upper surface side in Fig. 5) of the printed circuit board P along a center axis of the through hole H. A protruding length of the terminal T from the printed circuit board P is preferably set to 5 mm or below, and is more preferably set to 3 mm or below.

### <Nozzle>

The nozzle 24 has a circular cylindrical shape, and is formed using ceramic as a material.

The heater 36 is disposed on a rear end side (proximal portion side 25b) of the nozzle 24 such that the heater 36 surrounds the nozzle 24 concentrically from an outer peripheral side. As the heater 36, a ceramic heater having electric power capacity of 80 watt or 135 watt is used. The nozzle 24 is heated from the outer peripheral side by the heater 36.

The nozzle 24 can be formed of the following three divided portions in view of its functions.

That is, the nozzle 24 can be divided into: an insertion portion 24a at a nozzle distal end portion into which the terminal T is inserted; a melting portion 24b at a nozzle center portion where solder piece 2a is melted; and a guide portion 24c at a nozzle rear end portion which guides the solder piece 2a to a melting portion.

Further, in the melting portion 24b, a width of a space surrounded by an inner wall 25 of the nozzle 24 in cross section perpendicular to a center axis of the space (hereinafter, referred to as a minimum width) is assumed as an inner diameter S2. In the guide portion 24c, a width of the space surrounded by the inner wall 25 of the nozzle 24 in cross section perpendicular to the center axis of the space (hereinafter referred to as a minimum width) is assumed as an inner diameter S3.

An outer diameter of the solder piece 2a before being melted at a minimum width is assumed as D1, and an outer diameter of the solder piece 2a at a maximum width is assumed as D2. In this embodiment, a solder piece 2a obtained by cutting a wire solder is used and hence, the outer diameter D1 at the minimum width and the outer diameter D2 at the maximum width are equal. Further, the solder piece 2a is formed such that the solder piece 2a before being melted is held in a vertically or obliquely standing posture at a contact position AP which is a position at which an end portion 2b of the solder piece 2a before being melted on a terminal T side is brought into contact with a distal end Ts (solder piece supply side surface) of the terminal T. Although the solder piece 2a before being melted has a circular columnar shape, the shape of the solder piece 2a is not limited to such a shape. The solder piece 2a may be formed into a suitable shape having a size which allows the solder piece 2a to pass through the hole 26 of the nozzle 24 (a size along a plane perpendicular to a direction along which the solder piece 2a passes through the hole 26) and having a length (a length in a direction along which the solder piece 2a passes through the hole 26) larger than the size. An elliptical columnar shape, a polygonal columnar shape, an elliptical spherical shape or the like is considered as the shape of the solder piece 2a.

### <Insertion portion>

The insertion portion 24a of the nozzle 24 indicates a portion of the nozzle 24 surrounding the terminal T from the periphery of the terminal T. The insertion portion ranges from the distal end 24d of the nozzle 24 to a portion of the nozzle 24 disposed at the same position of the distal end Ts of the terminal T of the electronic part C.

The nozzle 24 of the insertion portion 24a is formed into a circular columnar shape having a fixed wall thickness, and is disposed such that a center axis of the nozzle 24 extends along the terminal T. The distal end surface 24d of the nozzle 24 is formed into a flat shape forming a flat surface perpendicular to the center axis, and is brought into contact with a surface of the land Rb on a back surface side of the printed circuit board P in parallel. With such a configuration, heat from the heater 36 which is transferred to the nozzle 24 is transferred to the land Rb on a back surface side due to heat transfer by way of the distal end surface 24d thus heating the whole land R.

The insertion portion 24a which surrounds the terminal T from the peripheral side heats the terminal T due to radiation heat transfer of far infrared ray which the high-temperature nozzle 24 radiates.

Further, air is introduced into the inside of the nozzle 24 in a direction from a rear end side to a distal end side of the nozzle 24 through an air supply passage 39 (see Fig. 3) by an air supply unit (not shown in the drawing). Air introduced into the nozzle 24 is heated during passing through the inside of the nozzle 24 heated by the heater 36 thus generating hot air, and hot air stays in the through hole H besides in the nozzle 24. The convection hot air heats the terminal T which is brought into contact with the hot air, a portion of the land Rb on a back surface side, and the land Rh which faces the through hole H due to convection heat transfer.

As has been described above, the insertion portion 24a heats the land R of the printed circuit board P and the terminal T of the electronic part C by making use of three kinds of transfer of heat, that is, heat transfer, radiation heat transfer and convection heat transfer. Accordingly, heat efficiency can be enhanced thus also realizing power saving.

Such heating is performed in the nozzle 24 and hence, the heating is minimally influenced by external disturbance.

Further, the insertion portion 24a of the nozzle 24 is formed such that a distance S1 between a side surface Tw of the terminal T (a solder piece supply side surface) and a distal end side 25a of the inner wall 25 of the nozzle 24 which faces the side surface Tw (a region in the vicinity of the terminal) is smaller than the outer diameter D1 which is a minimum width of the solder piece 2a before being melted. Accordingly, the solder piece 2a before being melted is restricted such that an end portion of the solder piece 2a before being melted on a terminal T side is not further moved toward a land R side from a contact position AP at which the end portion is held in a state where the end portion is brought into contact with the distal end Ts of the terminal T. That is, the inner wall 25 on the distal end side 25a functions as a contact position restricting unit which brings the end portion 2b of the solder piece 2a before being melted on a terminal T side supplied into the inside of the nozzle 24 into contact with the distal end Ts of the terminal T.

### <Melting portion>

The melting portion 24b of the nozzle 24 indicates a portion of the nozzle 24 ranging from the position of the nozzle 24 corresponding to the distal end Ts of the terminal T inserted into the nozzle 24 to the position of the nozzle 24 at which the solder piece 2a brought into contact with the distal end Ts exists. That is, the melting portion 24b indicates the portion of the nozzle 24 which surrounds the solder piece 2a in a state where the solder piece 2a used for soldering is brought into contact with the distal end Ts of the terminal T.

The nozzle 24 at the melting portion 24b is formed into a circular columnar shape having a fixed wall thickness. The nozzle 24 at the melting portion 24b is formed such that a center axis of the melting portion 24b agrees with the center axis of the insertion portion 24a.

The inner wall 25 of the nozzle 24 at the melting portion 24b is formed such that the inner diameter S2 which is a minimum width of a space surrounded by the inner wall 25 in cross section perpendicular to a center axis of the space is smaller than a diameter of a large circle of the true spherical solder piece 2a assuming that the solder piece 2a is melted at the contact position AP and is deformed into a true spherical shape without causing a change in mass (a diameter of a spherical shape of the melted wire solder).

The insertion portion 24a and the melting portion 24b are formed continuously with each other such that the inner wall 25 of the insertion portion 24a and the inner wall 25 of the melting portion 24b have the same inner diameter S2 of the inner wall 25. As described above, the inner diameter S2 is set equal to or below the diameter of the spherical shape of the melted wire solder and equal to or above the diameter of the through hole H (preferably, the inner diameter S2 being a diameter obtained by adding 0.1 mm or more to the diameter of the through hole H).

### <Guiding portion>

The guide portion 24c of the nozzle 24 indicates the inner wall 25 disposed on a proximal portion side 25b compared to the melting portion 24b.

The nozzle 24 at the guide portion 24c is formed into a circular columnar shape having a fixed wall thickness. The nozzle 24 at the guide portion 24c is formed such that a center axis of the guide portion 24c agrees with the center axis of the melting portion 24b thus guiding a supplied solder piece 2a into the melting portion 24b.

An inner diameter S3 of the guide portion 24c which is a minimum width of an end surface perpendicular to a center axis of a space surrounded by the inner wall 25 of the nozzle 24 is set larger than an outer diameter D2 which is a maximum width of the solder piece 2a before being melted.

The solder piece 2a is pre-heated by heat transferred from the nozzle 24 during a time where the solder piece 2a passes through the inside of the guide portion 24c. On the other hand, the solder piece 2a passes through the inside of the guide portion 24c smoothly within a short time and hence, there is no concern that the solder piece 2a is deformed or melted so that guiding of the solder piece 2a to the melting portion 24b is obstructed.

### <Manner of soldering operation >

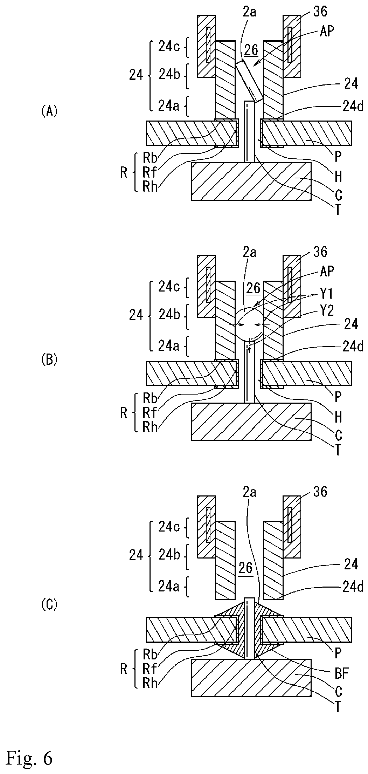

As shown in Fig. 6 (A) which is an end view, as a base material in performing soldering, the printed circuit board P having the land R is prepared where the terminal T of the electronic part C is inserted into the through hole H of the printed circuit board P in a direction from a surface side to a back surface side (from a lower surface side to an upper surface side in Fig. 6) of the printed circuit board P.

### <Positioning step>

The control part 61 moves the position of the nozzle 24 on an X-Y plane using the conveyance guide 7f in the Y direction and the conveyance guide 7c in the X direction and the drive mechanism parts 7b, 7e thus allowing the nozzle 24 to face the land R to be soldered. In such a positioning operation, the position of the nozzle 24 at this point of time is set to the position where the center of the land Rb on a back surface side of the printed circuit board P and the center of the nozzle 24 approximately agree with each other, or the position where the center of a distal end of the terminal T and the center of the nozzle 24 approximately agree with each other.

### <Nozzle approaching step>

The control part 61 moves the head portion 3 in a floating state in a direction approaching the land R along the conveyance guide 5c by the drive mechanism part 5b, and brings the distal end surface 24d of the nozzle 24 into contact with a surface of the land Rb on a back surface side of the printed circuit board P. With such an operation, a state is brought about where the distal end Ts of the terminal T is inserted into the insertion portion 24a of the nozzle 24.

At this stage of the operation, the terminal T is disposed away from the inner wall 25 of the nozzle 24 by a uniform distance, and a state where the terminal T and the nozzle 24 are spaced apart from each other in a non-contact state is maintained. With such a configuration, it is possible to prevent heat from being directly transferred to the terminal T from the nozzle 24, and the terminal T is gradually heated by radiation heat transfer and convection heat transfer. On the other hand, the land R of the printed circuit board P is rapidly heated by direct heat transfer from the nozzle 24 which is in contact with the land R and the transfer of heat due to convection heat transfer.

### <Solder piece supplying step>

In such a state, the control part 61 cuts a wire solder 2 by the rotary cutter 55 thus acquiring a solder piece 2a, and allows the wire solder 2a to pass through the hole 34a in the solder introducing cylinder 34 thus supplying the wire solder 2a to the inside of the nozzle 24. The solder piece 2a which falls from above and is supplied to the inside of the nozzle 24 is pre-heated during a time where the solder piece 2a passes through the guide portion 24c. An end portion 2b of the solder piece 2a is brought into contact with the distal end Ts of the terminal T so that the solder piece 2a is stopped at the contact position AP whereby the position and falling of the solder piece 2a are restricted. At this stage of the operation, the inner wall 25 of the nozzle 24 functions as a falling restricting portion for restricting the solder piece 2a from falling from a state where the solder piece 2a stands upright or obliquely on the distal end Ts of the terminal T.

### <Melting step>

The solder piece 2a before being melted which is guided to the contact position AP does not fall from the position, and at least a portion of the solder piece 2a such as an end portion of the solder piece 2a on a side opposite to the terminal T is positioned close to the heater 36, and is brought into contact with the inner wall 25 of the melting portion 24b whose temperature is higher than a temperature of the insertion portion 24a. Accordingly, the solder piece 2a before being melting which is disposed at the contact position AP is melted by transfer of heat by way of one end portion, both end portions, or a side portion of the solder piece 2a which is brought into contact with the inner wall 25 of the nozzle 24 of the melting portion 24b. In such melting of the solder piece 2a, in addition to the direct heat transfer due to contact with the nozzle 24, indirect heat transfer such as radiation heat transfer from the nozzle 24 at the melting portion 24b and convection heat transfer due to a hot air convection flow generated in the nozzle 24 are also performed.

The solder piece 2a has a tendency of being rounded and forming an approximately spherical shape due to a surface tension when melted. However, such a tendency of the solder piece 2a is restricted by the inner wall 25 of the nozzle 24 of the melting portion 24b and the distal end of the terminal T and hence, the solder piece 2a in a molten state cannot form a true spherical shape and, as shown in Fig. 6 (B) which is an end view, the solder piece 2a is deformed into a thick and short shape in a state where the solder piece 2a is brought into contact with the distal end Ts of the terminal T. Such a shape is a shape where both ends of a short circular column are respectively formed into a spherical surface.

By melting the solder piece 2a as described above, heat is transferred to the solder piece 2a from the nozzle 24 as indicated by an arrow Y1 and, further, heat is transferred to the terminal T from the solder piece 2a as indicated by an arrow Y2. Accordingly, the terminal T is further rapidly heated more than before. During such heating, the melted solder piece 2a is stopped without moving in a solder piece supply direction (downward direction) in a state where the melted solder piece 2a is brought into contact with the terminal T, that is, a state where the melted solder piece 2a is placed on the terminal T. The solder piece 2a is melted at a temperature of 217°C or above.

As shown in Fig. 6 (C) which is an end view, when the terminal T is heated to a suitable temperature by way of the melted solder piece 2a, the melted solder piece 2a starts to become wet and flows out from the distal end Ts of the terminal T along a side surface Tw of the terminal T. In this case, the solder piece 2a which is started to be melted but does not flow yet may be continuously deformed in shape being influenced by heat or the like while the solder piece 2a is stopped at the same position. Then, the melted solder piece 2a which flows out along the side surface Tw of the terminal T expands over the land Rb on the back surface side and, then, the melted solder piece 2a also flows into a gap formed between the side surface Tw of the terminal T and the land Rh which faces the through hole H due to a capillary phenomenon. Then, the melted solder piece 2a expands also over the land Rf on the surface side.

### <Nozzle separating step>

Thereafter, the control part 61 moves the head portion 3 in a floating state along the conveyance guide 5c in a direction moving away from the land R by the drive mechanism part 5b, and moves the distal end surface 24d of the nozzle 24 away from the surface of the land Rb on the back surface side of the printed circuit board P. With such an operation, the land R, the terminal T, and the melted solder piece 2a are rapidly cooled and hence, the melted solder piece 2a is solidified whereby the soldering operation is finished.

Due to the above-mentioned behavior of the melted solder piece 2a, the terminal T is soldered to the land R with certainty. With such a soldering, the applied solder exhibits a beautiful finish appearance, and also forms a beautiful back fillet shape BF.

Due to the above-mentioned configuration and operation, high accuracy soldering can be realized thus preventing the occurrence of defective soldering.

The insertion portion 24a of the nozzle 24 is formed such that a distance S1 between the side surface Tw of the terminal T and the inner wall 25 of the nozzle 24 which faces the side surface Tw is shorter than the outer diameter D1 which is a minimum width of the solder piece 2a before being melted. Accordingly, the solder piece 2a before being melted is prevented from further moving toward the land R side from the contact position AP. That is, the entrance of the solder piece 2a before being melted into the insertion portion 24a of the nozzle 24 is prevented. With such a configuration, it is possible to prevent non-uniform transfer of heat to the land R and the terminal T which are uniformly heated in the insertion portion 24a of the nozzle 24 which may be caused due to entrance of the solder piece 2a before being melted. As a result, it is possible to prevent occurrence of incomplete soldering attributed to a defect that a beautiful fillet shape is not formed.

The solder piece 2a melted at the contact position AP is restricted by the inner wall 25 of the nozzle 24 of the melting portion 24b and the distal end Ts of the terminal T and hence, the solder piece 2a is deformed into a thick and short shape. Accordingly, it is possible to newly transfer heat by direct heat conduction from the nozzle 24 to the terminal T by way of melted solder piece 2a thus rapidly heating the terminal T. With such an operation, solder wettability is enhanced thus forming a beautiful back fillet shape BF with favorable reproducibility. Further, even in a power device having large heat capacity thus having large heat dissipation and the like, a temperature of the terminal T can be easily increased to a proper temperature and hence, it is possible to prevent occurrence of defective soldering of an electronic part having large heat capacity.

A part which directly transfers heat to the terminal T is only the solder piece 2a and hence, the terminal T is sufficiently heated after the solder piece 2a is sufficiently melted whereby it is possible to prevent solder from flowing out inadvertently. That is, in the case where the increase of a temperature of the terminal T is faster than melting of the solder piece 2a, there is a possibility that a solder partially flows out in the midst of melting of the solder piece 2a thus causing inappropriate soldering. To the contrary, by orderly performing the following steps, that is, the step of holding the solder piece 2a in a sufficiently melted state in advance (step 1), the step of sufficiently heating terminal T (step 2) and the step of flowing out melted solder (step 3), it is possible to perform favorable soldering in a stable manner.

Further, the land R is directly heated by the nozzle 24 in advance and hence, the land R is sufficiently heated at a point of time that the solder flows out. With such heating, it is also possible to apply favorable soldering to the land R in a stable manner.

### EMBODIMENT 2

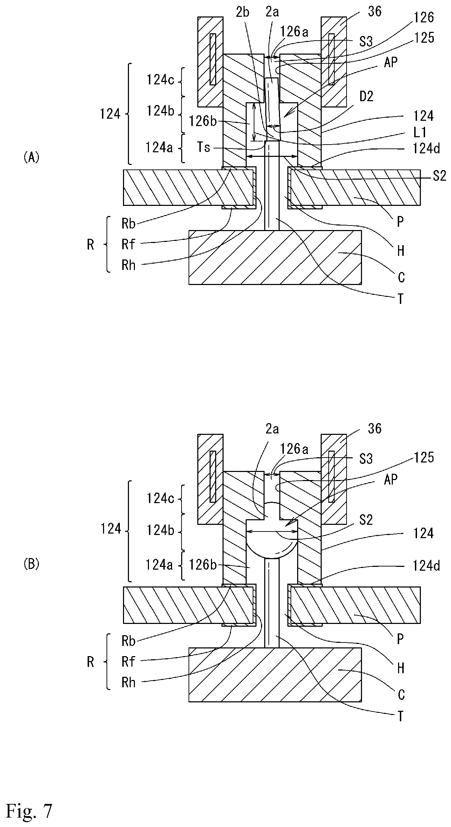

Fig. 7 is an explanatory view which is an end view schematically showing a nozzle 124 of an embodiment 2 and an area in the vicinity of the nozzle 124.

As show in Fig. 7 (A) which is the end view, the nozzle 124 is formed into a shape where a width of a hole 126a at a guide portion 124c is narrow, and a width of a hole 126b at a melting portion 124b and at an insertion portion 124a is large. An inner diameter S3 which is a minimum width of an end surface perpendicular to a center axis of a space surrounded by an inner wall 125 of the guide portion 124c is set slightly larger than an outer diameter D2 which is a maximum width of a solder piece 2a before being melted.

An inner diameter S2 of the melting portion 124b which is a minimum width of an end surface perpendicular to the center axis of the space surrounded by the inner wall 125 of the nozzle 124 is set smaller than a diameter of a large circle of a solder piece 2a having a true spherical shape in the case where it is assumed that the solder piece 2a is melted at a contact position AP and is deformed into a true spherical shape without causing a change in mass.

A distance L1 from a position at which the melting portion 124b and the guide portion 124c are switched to a distal end Ts of a terminal T which is inserted into a hole 126 is set smaller than a length of the solder piece 2a. The distance L1 is set such that a range where an inclination of the solder piece 2a can be changed is restricted by a portion of the solder piece 2a remaining in the hole 126 of the guide portion 124c in a state where the solder piece 2a is brought into contact with the distal end Ts of the terminal T and hence, even when the solder piece 2a is inclined at maximum within the restricting range, the end portion 2b of the solder piece 2a is brought into contact with the distal end Ts of the terminal T. Accordingly, the inner wall 125 of the guide portion 124c functions as a contact position restricting unit for bringing a terminal-T-side end portion 2b of the solder piece 2a before being melted supplied to the inside of the nozzle 124 into contact with the distal end Ts of the terminal T.

The nozzle 124 is formed such that an axis of the melting portion 124b and an axis of the guide portion 124c agree with each other.

With the above-mentioned configuration, the solder piece 2a supplied to the guide portion 124c passes through the guide portion 124c in a posture along the inner wall 125 of the nozzle 124 at the guide portion 124c, and is guided to the contact position AP of the melting portion 124b while maintaining such a posture. Then, the solder piece 2a guided to the contact position AP is restricted with respect to a movable range and an angle change range, the end portion 2b on a distal end side is brought into contact with the distal end Ts of the terminal T, and a rear end portion of the solder piece 2a is brought into contact with the inner wall 125 of the nozzle 124 at the guide portion 124c disposed adjacently to the melting portion 124b. In this manner, the movement of the rear end portion in a direction perpendicular to the guiding direction is restricted and hence, the posture of the solder piece 2a is maintained as it is also at the contact position AP whereby the solder piece 2a is brought into a vertically or obliquely standing state. At this stage of operation, the inner wall 125 of the nozzle 124 functions as a falling restricting portion for preventing the solder piece 2a from falling from a state where the solder piece 2a stands vertically or obliquely on the distal end Ts of the terminal T.

The solder piece 2a passes through the guide portion 124c in a posture along the inner wall 125 of the nozzle 124 at the guide portion 124c, and is guided to the melting portion 124b while maintaining such a posture and hence, even in the case where the nozzle 124 and the terminal T are slightly displaced from each other in a lateral direction, the solder piece 2a can be disposed at the contact position AP.

The rear end portion of the solder piece 2a before being melted is brought into contact with the inner wall 125 of the nozzle 124 at the guide portion 124c which is disposed adjacently to the melting portion 124b and hence, the rear end portion of the solder piece 2a receives heat transferred by mainly heat conduction from the nozzle 124. On the other hand, the distal end portion of the solder piece 2a before being melted receives heat transferred by radiation heat transfer and convection heat transfer. Accordingly, the rear end portion of the solder piece 2a is heated more rapidly than the distal end portion and hence, the solder piece 2a is gradually melted from a rear end portion side toward a distal end portion side.

The mode where the solder piece 2a is melted at the contact position AP is constant as described above and hence, the mode exhibits favorable reproducibility. Accordingly, it is possible to suppress the occurrence of defective soldering attributed to irregularities in a change in shape of the solder piece 2a during melting.

As shown in Fig. 7 (B) which is an end view, the solder piece 2a melted at the contact position AP is also partially restricted by the inner wall 125 of the nozzle 124 at the guide portion 124c in addition to the inner wall 125 of the nozzle 124 at the melting portion 124b and the distal end of the terminal T and hence, the shape of the solder piece 2a is changed. Accordingly, the melted solder piece 2a can receive heat transferred by heat conduction from the inner wall 125 of the nozzle 124 having a larger surface area. Then, this transferred heat is transferred to the terminal T thus heating the terminal T more rapidly. Accordingly, such a heating is preferable to prevent the occurrence of defective soldering of an electronic part having large heat capacity thus having large heat dissipation.

Also in the case where the nozzle 124 of the embodiment 2 is used, substantially the same manner of operation and advantageous effects can be acquired as the embodiment 1.

### EMBODIMENT 3

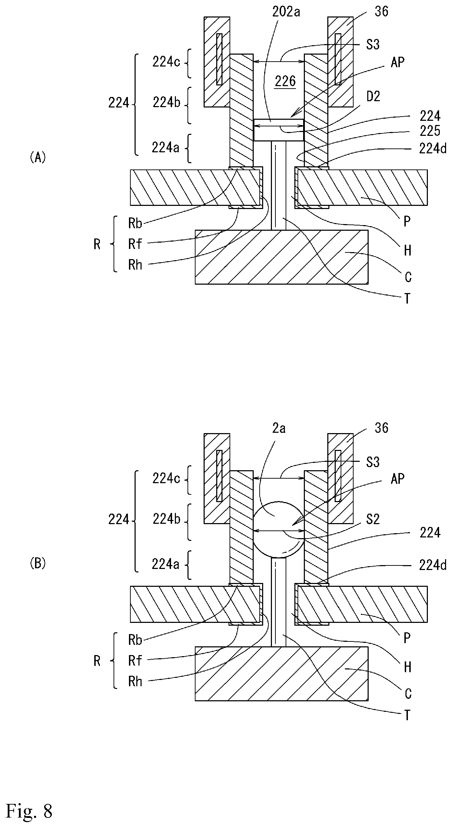

Fig. 8 is an explanatory view which is an end view schematically showing a nozzle 224 of an embodiment 3 and an area in the vicinity of the nozzle 224.

As shown in Fig. 8 (A) which is an end view, the nozzle 224 has the same configuration as the nozzle 24 of the embodiment 1, and a solder piece 202a may be made thick. In this case, it is sufficient for the solder piece 202a to have a diameter smaller than an inner diameter S2 by about one size, the inner diameter S2 which is a minimum width of an end surface perpendicular to a center axis of a space surrounded by an inner wall 225 of a melting portion 224b of the nozzle 224.

In this case, the inner wall 225 of the melting portion 224b functions as a contact position restricting unit for bringing the end portion 2b on a terminal T side of the solder piece 2a before being melted supplied to the inside of the nozzle 224 into contact with a distal end Ts of the terminal T.

With the above-mentioned configuration, the solder piece 202a supplied to the guide portion 224c passes through the guide portion 224c in a posture along the inner wall 225 of the nozzle 224 of the guide portion 224c, and is guided to the melting portion 224b while maintaining such a posture. In this case, even when the nozzle 224 and the terminal T are largely displaced from each other in a lateral direction, a portion of the end portion of the solder piece 202a on a terminal T side is surely brought into contact with the distal end of the terminal T and hence, the solder piece 202a guided to the melting portion 224b can be arranged at the contact position AP with certainty.

A distal end of the solder piece 202a guided to the contact position AP is brought into contact with the distal end of the terminal T, and a peripheral portion of the solder piece 202a is brought into contact with or approaches the inner wall 225 of the nozzle 224 of the melting portion 224b. Accordingly, the solder piece 202a at the contact position AP is restricted not only in the movement in the guiding direction but also in the movement in a direction perpendicular to the guiding direction and hence, the solder piece 202a is brought into a vertically or obliquely standing state. In this case, the inner wall 225 of the nozzle 224 functions as a falling restricting portion for restricting falling of the solder piece 202a from a state where the solder piece 202a vertically or obliquely stands on the distal end Ts of the terminal T.

Further, the peripheral portion of the solder piece 202a before being melt is brought into contact with or approaches the inner wall 225 of the nozzle 224 of the melting portion 224b and hence, the peripheral portion of the solder piece 202a strongly receives heat transferred by the heat conduction and the radiation heat transfer from the nozzle 224.

Accordingly, the solder piece 202a at the contact position AP is gradually melted from the peripheral portion toward a center portion, and the mode of melting of the solder piece 202a is always constant and hence, the mode exhibits favorable reproducibility. Accordingly, it is possible to suppress the occurrence of defective soldering attributed to irregularities in a change in shape of the solder piece 202a during melting.

As shown in Fig. 8 (B) which is an end view, also in this case, the solder piece 202a melted at the contact position AP is deformed into a thick short shape by being restricted by the inner wall 225 of the nozzle 224 of the melting portion 224b and the distal end of the terminal T. Then, the melted soldering piece 202a receives heat transferred by heat conduction from the inner wall 225 of the nozzle 224, and transfers heat to the terminal T. With such a configuration, the terminal T can be rapidly heated.

Also in the case where the nozzle 224 of the embodiment 3 is used, substantially the same manner of operation and advantageous effects can be acquired as the embodiment 1.

### EMBODIMENT 4

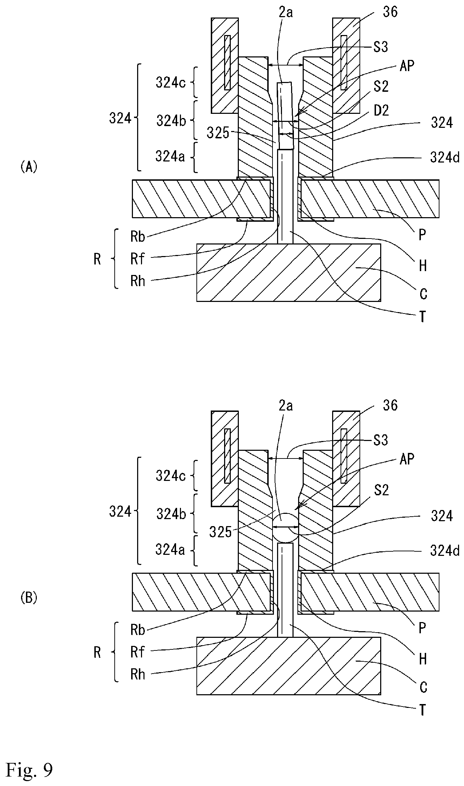

Fig. 9 is an end view schematically showing a nozzle 324 of an embodiment 4 and an area in the vicinity of the nozzle 324, and Fig. 9 (A) is an end view showing a state where an end portion 2b of a solder piece 2a before being melted on a terminal T side is brought into contact with a distal end Ts of a terminal T, and Fig. 9 (B) is an end view showing a state where the solder piece 2a is melted.

The nozzle 324 is formed such that an inner wall 325 of the nozzle 324 of a guide portion 324c is formed into a cylindrical shape, and a portion disposed adjacently to a melting portion 324b is formed into a truncated conical shape where a diameter is gradually decreased toward the melting portion 324b.

In this case, in the same manner as the embodiment 1, the inner wall 325 of the melting portion 323c functions as a contact position restricting unit for bringing an end portion 2b of a solder piece 2a before being melted on a terminal T side supplied to the inside of the nozzle 324 into contact with a distal end Ts of the terminal T. In this case, the inner wall 325 of the nozzle 324 functions as a falling restricting portion for restricting falling of the solder piece 2a from a state where the solder piece 2a stands vertically or obliquely on the distal end Ts of the terminal T.

With the above-mentioned configuration, a wide gap can be ensured between the guide portion 324c and the solder piece 2a so that the solder piece 2a can be moved smoothly. Further, when the solder piece 2a passes through the portion having the truncated conical shape where the diameter is gradually decreased, disturbance in posture of the solder piece 2a which occurs in the solder piece 2a at the time of passing through the guide portion 324c can be corrected. Further, the solder piece 2a can be guided to a contact position AP with favorable reproducibility in a predetermined posture and hence, the solder piece 2a can be restricted to a vertically or obliquely standing state. Accordingly, irregularities in a succeeding soldering operation can be reduced thus suppressing the occurrence of defective soldering.

Also in the case where the nozzle 324 of the embodiment 4 is used, substantially the same manner of operation and advantageous effects can be acquired as the embodiment 1.

### EMBODIMENT 5

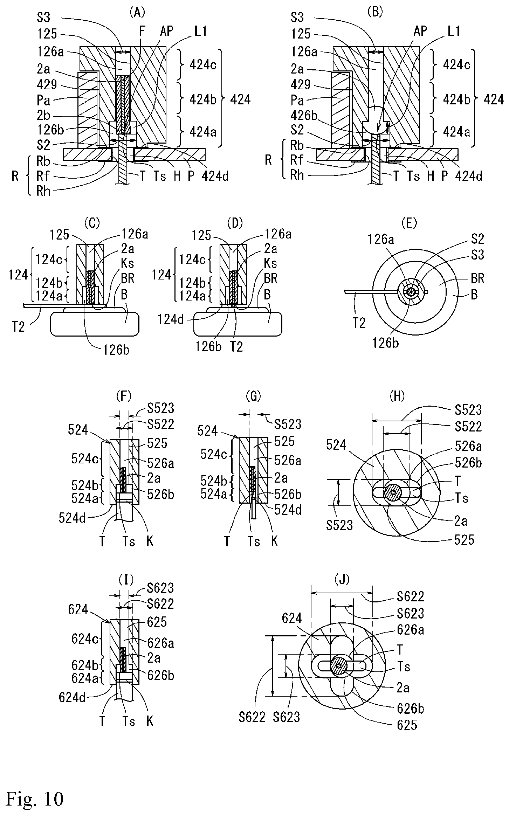

Fig. 10 (A) is a cross-sectional view schematically showing a nozzle 424 of an embodiment 5 and an area in the vicinity of the nozzle 424, and Fig. 10 (B) is a cross-sectional view schematically showing the nozzle 424 and the area in the vicinity of the nozzle 424 in a state where a solder piece is melted in the embodiment 5.

As shown in Fig. 10 (A) which is a cross-sectional view, in the same manner as the embodiment 2, the nozzle 424 has a hole 126 formed of: a hole 126a having a narrow width and formed in a guide portion 424c; and a hole 126b having a wide width and formed in a melting portion 424b and an insertion portion 424a respectively.

The nozzle 424 includes a part avoiding recessed portion 429 at a portion of an outer periphery on a distal end side for avoiding contact of the nozzle 424 with a part Pa disposed on a printed circuit board P. Further, a distal end portion of the nozzle 424 is formed such that a portion which faces a land R and forms a center portion of the distal end portion protrudes slightly downward such that a nozzle distal end surface 424d becomes slightly smaller than a land back surface portion Rb of the land R. In other words, the nozzle 424 is formed to have a thick wall thickness from a portion on a slightly proximal portion side of the nozzle distal end surface 424.

An inner wall 125 of the nozzle 424, a through hole H, the land R (Rb, Rf, Rh), a printed circuit board P, an inner diameter S2, an inner diameter S3, a terminal T, and a distal end Ts of the terminal T are equal to the corresponding constitutional elements of the embodiment 2 respectively and hence, these constitutional elements are given the same symbols, and the detailed description of these constitutional elements is omitted.

Also in the case where the nozzle 424 of the embodiment 5 is used, substantially the same manner of operation and advantageous effects can be acquired as the embodiment 2.

### EMBODIMENT 6

Fig. 10 (C) to Fig. 10 (E) show a configuration of a nozzle 124 of an embodiment 6 and an area in the vicinity of the nozzle 124 where a lead terminal T2 (first conductor) is soldered to a button battery B using the nozzle 124 having the same structure as the nozzle of the embodiment 2. In these drawings, Fig. 10 (C) is a front view, Fig. 10 (D) is a right side view, and a Fig. 10 (E) is a plan view.

As shown in the drawings, the lead terminal T2 extending straightly is placed on a surface of a disc-shaped minus electrode BR (second conductor) disposed on a back surface (an upper surface in the drawing) of the button battery B such that the lead terminal T2 is brought into contact with an outer peripheral surface of the minus electrode BR, and a nozzle distal end surface 124d which is a distal end of the nozzle 124 is brought into contact with an upper surface of the lead terminal T2 (an outer peripheral surface of the lead terminal T2 on a side opposite to an outer peripheral surface of the lead terminal T2 which is brought into contact with the minus electrode BR) from above (a side opposite to the minus electrode BR). In this case, the nozzle distal end surface 124d is slightly spaced apart from the surface of the minus electrode BR of the button battery B only by a thickness of the lead terminal T2, and is placed on the lead terminal T2.

The solder piece 2a supplied to a hole 126 in such a state is placed on the lead terminal T2 in a standing state. In this case, the solder piece 2a takes a standing posture, and is restricted (temporarily stopped) by the inner wall 125 of the hole 126a of the guide portion 124c having a narrow width such that the solder piece 2a before being melted does not fall from the lead terminal T2.

Also in the case where the nozzle 424 of the embodiment 6 is used, substantially the same manner of operation and advantageous effects can be acquired as the embodiment 2.

In this embodiment, the nozzle distal end surface 124d of the nozzle 124 is formed approximately horizontally. However, the present invention is not limited to such a configuration, and a configuration may be adopted where one straight groove having the same width and the same height (equal to the width) as the lead terminal T2 is formed in a radial direction, and the lead terminal T2 is accommodated in the groove. In this case, the nozzle distal end surface 124d of the nozzle 124 can be brought into contact with the minus electrode BR of the button battery B so that an effect of preventing scattering of a flux or the like can be also enhanced.

### EMBODIMENT 7

Fig. 10 (F) to Fig. 10 (H) are explanatory views for describing a nozzle 524 of an embodiment 7, wherein Fig. 10 (F) is a front view with a part in longitudinal cross section, Fig. 10 (G) is a right side view with a part in longitudinal cross section, and Fig. 10 (H) is a plan view with a part in transverse cross section.

As shown in Fig. 10 (G), the nozzle 524 is formed such that a hole 526a formed in a guide portion 524c has a narrow inner diameter S523 and has a circular shape in transverse cross section, and a hole 526b formed in a melting portion 524b and an insertion portion 524a has a large inner diameter S522 and has a shape where both short sides of a rectangular shape protrude in an arcuate shape in transverse cross section.

That is, as shown in Fig. 10 (F), as viewed in a front view in longitudinal cross section, the hole 526 has a narrow width at the guide portion 524c and a wide width at the melting portion 524b and the insertion portion 524a. As shown in Fig. 10 (G), as viewed in a right side view in longitudinal cross section, the hole 526 has the same width at the guide portion 524c, the melting portion 524b, and the insertion portion 524a.

An inner diameter S523 of the guide portion 524c which is a minimum width of an end surface perpendicular to a center axis of a space surrounded by the inner wall 525 is slightly larger than an outer diameter (thickness) of a solder piece 2a before being melted which is a maximum width of the solder piece 2a before being melted. A hole 526b formed in the melting portion 524b and the insertion portion 524a is set slightly larger than an outer shape (thickness) of a flat-plate-like terminal T.

A lead line K (second conductor) is wound around the flat-plate-like terminal T on an outer periphery in the vicinity of a distal end Ts at a position slightly away from the distal end Ts.

Also in the case where the nozzle 524 of the embodiment 7 is used, substantially the same manner of operation and advantageous effects can be acquired as the embodiment 2. Further, the hole 526b formed in the melting portion 524b and the insertion portion 524a is formed in a large flat plate shape and hence, soldering can be performed in a state where the flat-plate-like terminal T is inserted into the hole 526b.

Further, the supplied solder piece 2a is placed on the terminal T in a state where a lower end of the solder piece 2a is brought into contact with the distal end Ts of the terminal T in a vertically or obliquely standing state, and the movement of the solder piece 2a in a standing state is restricted by the inner wall 525 of the insertion portion 524a. Accordingly, it is possible to prevent further falling of the solder piece 2a before being melted and hence, the solder piece 2a can be melted on the distal end Ts. Further, the melted solder piece 2a flows along the terminal T and hence, the terminal T and the lead line K can be electrically connected to each other.

### EMBODIMENT 8

Fig. 10(I) to Fig. 10 (J) are explanatory views for describing a nozzle 624 of an embodiment 8, wherein Fig. 10(I) is a front view with a part in longitudinal cross section, and Fig. 10 (J) is a plan view with a part in transverse cross section.

The nozzle 624 is formed such that a hole 626a formed in a guide portion 624c has a narrow inner diameter S623 and has a circular shape in transverse cross section, and a hole 626b formed in a melting portion 624b and an insertion portion 624a has a large inner diameter S622 and has a shape where respective distal ends of a + shape (plus shape) protrude in an arcuate shape respectively in transverse cross section.

That is, as shown in Fig. 10(I), as viewed in a front view in longitudinal cross section, the hole 626 has a narrow width in the guide portion 624c and has a wide width in the melting portion 624b and the insertion portion 624a. The hole 626 has the same shape also as viewed in a right side view in longitudinal cross section.

An inner diameter S623 of the guide portion 624c which is a minimum width of an end surface perpendicular to a center axis of a space surrounded by the inner wall 625 is set slightly larger than an outer diameter (thickness) which is a maximum width of the solder piece 2a before being melted. The hole 626b formed in the melting portion 624b and the insertion portion 624a is formed into a + shape which is formed making rectangular shapes each of which is slightly larger than an outer shape (thickness) of the flat-plate-like terminal T intersect with each other at 90 degrees.

A lead line K is wound around the flat-plate-like terminal T on an outer periphery in the vicinity of a distal end Ts at a position slightly away from the distal end Ts.

Also in the case where the nozzle 624 of the embodiment 8 is used, substantially the same manner of operation and advantageous effects can be acquired as the embodiment 2. Further, the hole 626b formed in the melting portion 624b and the insertion portion 624a is formed in a large shape where flat-plate-like shapes intersect with each other at 90 degrees and hence, soldering can be performed in a state where the flat-plate-like terminal T is inserted into the hole 626b. Particularly, since the hole 626b has a + shape, even when the flat-plate-like terminal T is arranged in various directions which differ from each other by 90 degrees as viewed in a plan view, the soldering can be performed properly in a state where each terminal T is inserted into the hole 626b.

Further, the supplied solder piece 2a is placed on the terminal T in a state where a lower end of the solder piece 2a is brought into contact with the distal end Ts of the terminal T in a vertically or obliquely standing state, and the movement of the solder piece 2a in a standing state is restricted by the inner wall 625 of the insertion portion 624a and hence, it is possible to prevent further falling of the solder piece 2a before being melted whereby the solder piece 2a can be melted on the distal end Ts. Further, the melted solder piece 2a flows along the terminal T and hence, the terminal T and the lead line K can be electrically connected to each other.

### EMBODIMENT 9

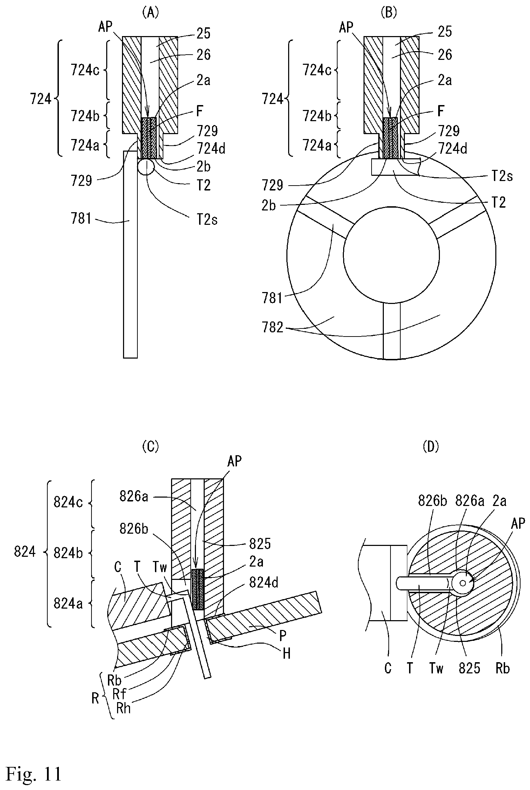

Fig. 11 (A) and Fig. 11 (B) are explanatory views for describing a nozzle 724 of an embodiment 9, wherein Fig. 11 (A) is a front view with a part in longitudinal cross section, and Fig. 11 (B) is a right side view with a part in longitudinal cross section.

The nozzle 724 is formed such that a hole 26 is formed into a circular columnar shape and has the same size at any positions of a guide portion 724c, a melting portion 724b, and an insertion portion 724a in the same manner as the embodiment 1. The nozzle 724 is also formed such that an outer diameter of the insertion portion 624a is small, and an outer diameter of the guide portion 624c and the melting portion 624b is large.

On a disc-like varistor 781, three electrodes 782 formed by splitting a ring shape in three are disposed. A lead terminal T2 extending straightly is disposed on a surface of one of these electrodes 782 (second conductor) such that an outer peripheral surface of the lead terminal T2 is brought into contact with the surface of the electrode 782. A nozzle distal end surface 724d which is a distal end of the nozzle 724 is brought into contact with an upper surface of the lead terminal T2 from above. That is, the lead terminal T2 which is a first conductor forming an object to be connected is brought into contact with the nozzle 724 at a lower position of the nozzle 724. With respect to the electrode 782 which is a second conductor forming an object to be connected, a surface of the electrode 782 which forms a soldering surface is disposed vertically or approximately vertically, and is brought into contact with or approaches a side surface of the insertion portion 724a of the nozzle 724. The hole 26 of the nozzle 724 is formed such that a diameter of the hole 26 is smaller than a length obtained by adding a thickness (diameter) of the lead terminal T2 and a minimum width (thickness) of a solder piece 2a.

With such a configuration, the nozzle 724 is restricted such that the further downward movement of the solder piece 2a before being melted is prevented in a state where a lower distal end of the solder piece 2a is brought into contact with the lead terminal T2 and is placed on the lead terminal T2. When the solder piece 2a is melted, the melted solder piece 2a flows out along the lead terminal T2 and hence, the lead terminal T2 and the electrode 782 are soldered to each other.

In this manner, substantially the same manner of operation and advantageous effects can be acquired also by using the nozzle 724 of the embodiment 9 as the embodiment 1.

### EMBODIMENT 10

Fig. 11 (C) and Fig. 11 (D) are explanatory views for describing a nozzle 824 of an embodiment 10, wherein Fig. 11 (C) is a front view with a part in longitudinal cross section, and Fig. 11 (D) is a plan view with a part in transverse cross section,

The nozzle 824 is formed such that a hole 826 formed in the nozzle 824 is formed of: a circular columnar-shaped hole 826a having the same size at a guide portion 824c and a melting portion 824b; and a insertion portion 724a is formed of a hole 826b where a portion of a circular columnar shape having the same size as the circular columnar-shaped hole 826a penetrates the nozzle 824 to an outer periphery of the nozzle 824. As a result, the hole 826 is formed in an L shape as a whole. A terminal T disposed on an electronic part C of a printed circuit board P is inserted into the flat-plate-like portion of the hole 826b which penetrates the nozzle 824 to the outer periphery of the nozzle 824. To be more specific, unlike the embodiment 1 where the soldering is applied to the back surface of the printed circuit board P, in this embodiment 10, the printed circuit board P is inclined such that soldering can be applied to a surface of the printed circuit board P on which the electronic part C is mounted. Further, due to such an inclination, a leg portion of the terminal T which originally extends upright is inclined. The hole 826b is formed such that an outer side Tz (solder piece supply side surface) of the terminal T disposed outside the inclined leg portion is inserted into the hole 826b close to an approximately center of the hole 826b.

Here, a positional relationship between the hole 826 and the terminal T is set such that the outer side Tz passes through a position below the hole 826a so that a gap formed between the outer side Tz and an inner surface of the hole 826b becomes smaller than an outer diameter (thickness) of a solder piece 2a. With such a configuration, a lower distal end of the solder piece 2a is brought into contact with the outer side Tz of the terminal T, and the other portion of the solder piece 2a is brought into contact with the inner wall 825 of the hole 826 and hence, the solder piece 2a before being melted is restricted such that the solder piece 2a does not fall further downward (temporarily stopped).

The distal end 824d of the nozzle 824 is formed of an inclined surface having the same inclination as the inclination of the printed circuit board P. With such a configuration, while keeping the hole 826 of the nozzle 824 in a vertical direction, the distal end 824d can be brought into contact with a land Rf on a surface (second conductor) of the inclined land R with no gap therebetween.

With such an operation, by restricting the position of the solder piece 2a before being melted in a state where the solder piece 2a is brought into contact with the outer side Tz so that the solder piece 2a stands, the solder piece 2a flows out along the terminal T after being melted and hence, soldering of the terminal T and the land R can be realized. Accordingly, the embodiment 10 can also acquire the same manner of operation and advantageous effects as the above-mentioned respective embodiments 1 to 9.

With respect to correspondence relationship between the present invention and the embodiments,
the solder piece supply unit corresponds to the rotary cutter 55, the solder introducing cylinder 34, and the pushing rod 59,
the heating unit corresponds to the heater 36,
the relative distance changing unit corresponds to the approaching or moving-away direction moving unit 6,
a minimum width of a solder piece corresponds to the outer shape D1, and
a minimum width of an end surface of a space surrounded by an inner wall of a nozzle of the melting portion perpendicular to a center axis of the space corresponds to the inner diameter S2. However, the present invention is not limited to the embodiments of the present invention, and various modifications are conceivable.

For example, an object to be connected is not limited to the land R, and may be suitably set to an object electrically connected to a terminal T such as an end portion of a coil wound around the terminal T (not shown in the drawing). In this case, a distal end Ts of a nozzle 24 is not brought into contact with the land R unlike the above-mentioned respective embodiments. However, soldering can be performed in a state where the distal end Ts of the solder piece 2a is inserted into the distal end side 25a of the nozzle 24. Also in this case, the same manner of operation and advantageous effects can be acquired as the above-mentioned respective embodiment and, at the same time, it is possible to generate a flow of an electric signal by soldering the terminal T and the coil end portion using the solder piece 2a to each other.

Further, a configuration may be adopted where the insertion portion 24a of the nozzle 24 is eliminated, and the distal end portion of the nozzle 24 forms the melting portion 24b. In this case, the distal end Ts of the terminal T may be made to approach a center position of the distal end side 25a of the nozzle 24, a solder piece 2a may be supplied in such a state, and the solder piece 2a may be deformed into an approximately spherical shape by melting the solder piece 2a. Also in this case, heat is transferred to the terminal T from the melted solder piece 2a, and the melted solder piece 2a flows along the terminal T thus soldering the terminal T and an object to be connected (land R or coil end portion) to each other. In the above-mentioned respective embodiments, it is possible to acquire advantageous effects such as applying of radiation heat to the terminal T by inserting the distal end Ts of the terminal T in the nozzle 24 and the like. Accordingly, the above-mentioned respective embodiments are more preferable than the above-mentioned case.

### INDUSTRIAL APPLICABILITY

The present invention is applicable to industrial fields where soldering is performed in production facility.

### REFERENCE SIGNS LIST

- 1:: Soldering apparatus
- 2a:: Solder piece
- 6:: Approaching or moving-away direction moving unit
- 20:: Nozzle unit
- 24, 124, 224, 324, 424, 524, 624, 724, 824:: Nozzle
- 30:: Heater unit
- 34:: Solder introducing cylinder
- 36:: Heater
- 55:: Rotary cutter
- 59:: Pushing rod
- 124c:: Guide portion
- D1:: Outer diameter
- R:: Land
- S1:: Distance
- S2:: Inner diameter
- T, T2:: Terminal
- Ts:: Distal end
- Tz:: Outer side

## Claims

1. A soldering apparatus for soldering a terminal and an object to be connected which is electrically connected to the terminal to each other, the soldering apparatus comprising:
a cylindrical nozzle into which at least a distal end of the terminal is inserted or which at least the distal end approaches;
a solder piece supply unit for supplying a solder piece to the inside of the nozzle;
a heating unit for melting the solder piece by heating;
a relative distance changing unit for changing a relative distance between the terminal and the nozzle in an approaching or moving-away direction; and
a contact position restricting unit which brings an end portion of the solder piece on a terminal side before being melted supplied to the inside of the nozzle into contact with the terminal thus restricting the solder piece before being melted to be held in the nozzle by preventing the solder piece from coming into contact with the object to be connected, wherein
the contact position restricting unit is formed of
an inner wall of the nozzle where a distance between the inner wall of the nozzle and a side surface of the terminal is set shorter than a minimum width of the solder piece before being melted or
a guide portion which guides the solder piece before being melted to the contact position in a predetermined posture thus restricting a movable range of the solder piece in a direction perpendicular to a guiding direction.

2. A soldering apparatus for soldering a terminal and an object to be connected which is electrically connected to the terminal to each other, the soldering apparatus comprising:
a cylindrical nozzle into which at least a distal end of the terminal is inserted or which the distal end approaches;
a solder piece supply unit for supplying a solder piece to the inside of the nozzle;
a heating unit for melting the solder piece by heating;
a relative distance changing unit for changing a relative distance between the terminal and the nozzle in an approaching or moving-away direction; and
a contact position restricting unit which brings an end portion of the solder piece on a terminal side before being melted supplied to the inside of the nozzle into contact with a distal end of the terminal thus restricting the solder piece before being melted to be held at a contact position where an end portion of the solder piece on a terminal side is brought into contact with the distal end of the terminal in the nozzle by preventing the solder piece before being welded from coming into contact with the object to be connected.

3. The soldering apparatus according to claim 1 or 2, wherein the heating unit is disposed at a position where heat is transferred to the solder piece which is brought into contact with the distal end of the terminal by way of the nozzle, deforms the solder piece before being melted into a thick and short shape by melting the solder piece at the contact position.

4. The soldering apparatus according to claim 1, 2 or 3, wherein the nozzle has a cylindrical melting portion where the solder piece which is to be melted at the contact position where the solder piece is brought into contact with the distal end of the terminal and is to be formed into an approximately spherical shape is brought into contact with the inner wall of the nozzle, and
a minimum width of the end surface of a space surrounded by the inner wall of the nozzle at the melting portion perpendicular to a center axis of the space is smaller than a diameter of a true sphere in a case where the solder piece is melted at the contact position and is deformed into one true spherical shape.

5. A soldering method using the soldering apparatus according to any one of claims 1 to 4, the soldering method comprising the steps of:
inserting at least the distal end of the terminal into the nozzle or making at least the distal end of the terminal approach the nozzle by the relative distance changing unit which changes the relative distance between the terminal and the nozzle in the approaching or moving-away direction;
supplying the solder piece to the inside of the nozzle by the solder piece supplying unit;
bringing the end portion of the supplied solder piece before being melted into contact with the terminal by the contact position restricting unit; and
melting by heating the solder piece by the heating unit by restricting the solder piece before being melted such that the solder piece does not move towards the terminal side by the contact.

6. A method of manufacturing a printed circuit board using the soldering apparatus according to any one of claims 1 to 4, the method comprising the steps of:
inserting at least the distal end of the terminal into the nozzle or making at least the distal end of the terminal approach the nozzle by the relative distance changing unit which changes the relative distance between the terminal and the nozzle in the approaching or moving-away direction;
supplying the solder piece to the inside of the nozzle by the solder piece supplying unit;
bringing the terminal-side end portion of the supplied solder piece before being melted into contact with the terminal by the contact position restricting unit;
melting by heating the solder piece by the heating unit by restricting the solder piece before being melted such that the solder piece does not move toward the terminal side by the contact;
soldering the terminal of the electronic part to a land of a printed circuit board by the melted solder piece.

7. A method of manufacturing a product using the soldering apparatus according to any one of claims 1 to 4, the method comprising the steps of:
inserting at least the distal end of the terminal into the nozzle or making at least the distal end of the terminal approach the nozzle by the relative distance changing unit which changes the relative distance between the terminal and the nozzle in the approaching or moving-away direction;
supplying the solder piece to the inside of the nozzle by the solder piece supplying unit;
bringing the terminal-side end portion of the supplied solder piece before being melted into contact with the terminal by the contact position restricting unit;
melting by heating the solder piece by the heating unit by restricting the solder piece before being melted such that the solder piece does not move toward the terminal side by the contact; and
soldering the terminal and the object to be connected by the melted solder piece to each other.

8. A method of manufacturing a soldered product comprising:
a nozzle approaching step where a first conductor and a nozzle are made to approach each other or are brought into contact with each other by changing a relative distance between the first conductor and the nozzle in an approaching or moving-away direction by a relative distance changing unit;
a solder piece supplying step where a solder piece supplied by a solder piece supplying unit is inserted into a hole formed in the nozzle; and
a melting step where the solder piece in the nozzle is melted by heating using a heating unit, wherein
a soldered product is manufactured by soldering the first conductor and a second conductor by the melted solder piece,
the nozzle includes a falling restricting portion which restricts falling of a lower end portion of the solder piece before being melted or a portion in a vicinity of the lower end portion from a state where the lower end portion or the portion in the vicinity of the lower end portion is brought into contact with a solder piece supply side surface of the first conductor, and
the melting step is configured such that the solder piece is melted at a position where falling of the lower end portion of the solder piece or the portion in the vicinity of the lower end portion is restricted by the falling restricting portion.

9. The method of manufacturing a soldered product according to claim 8, wherein the falling restricting portion is formed not to restrict a downward flow of a melted solder which is formed by melting of the solder piece.

10. The method of manufacturing a soldered product according to claim 8 or 9, wherein the melting step is configured to heat the first conductor through the solder piece heated by the heating unit.

11. The method of manufacturing a soldered product according to claim 8, 9 or 10, wherein the melting step is configured such that the solder piece whose falling is restricted by the falling restricting portion is melted at the position thus forming the solder piece into an approximately spherical shape or a deformed spherical shape where a sphere is deformed by being restricted in a hole of the nozzle and, thereafter, the melted solder in an approximately spherical shape or in a deformed spherical shape flows downward.

12. A soldered product manufactured by the soldered product manufacturing method according to any one of claims 8 to 11.

13. A soldering method comprising:
a nozzle approaching step where a first conductor and a nozzle are made to approach each other or are brought into contact with each other by changing a relative distance between the first conductor and the nozzle in an approaching or moving-away direction by a relative distance changing unit;
a solder piece supplying step where a solder piece supplied by a solder piece supplying unit is inserted into a hole formed in the nozzle; and
a melting step where the solder piece in the nozzle is melted by heating using a heating unit, wherein
the first conductor and a second conductor are soldered to each other by the melted solder piece,
the nozzle includes a falling restricting portion which restricts falling of a lower end portion of the solder piece before being melted or a portion in a vicinity of the lower end portion from a state where the lower end portion or the portion in the vicinity of the lower end portion is brought into contact with a solder piece supply side surface of the first conductor, and
the melting step is configured such that the solder piece is melted at a position where falling of the lower end portion of the solder piece or the portion in the vicinity of the lower end portion is restricted by the falling restricting portion.

14. A soldering apparatus comprising:
a relative distance changing unit formed to make a first conductor and a nozzle approach each other or to bring the first conductor and the nozzle into contact with each other by changing a relative distance between the first conductor and the nozzle in an approaching or moving-away direction;
a solder piece supplying unit formed to insert a solder piece into a hole formed in the nozzle; and
a heating unit formed to melt the solder piece in the nozzle by heating the solder piece, wherein
the nozzle includes a falling restricting portion which restricts falling of a lower end portion of the solder piece before being melted or a portion in a vicinity of the lower end portion from a state where the lower end portion or the portion in the vicinity of the lower end portion is brought into contact with a solder piece supply side surface of the first conductor, and
the heating unit is formed to melt the solder piece by heating the solder piece at a position where falling of the lower end portion of the solder piece or the portion in the vicinity of the lower end portion is restricted by the falling restricting part by heating.
